# FASCICULE DE BREVET EUROPEEN

(11) **EP 1 793 659 B1**
(45) Date de publication et mention de la délivrance du brevet: **06.01.2010**
(21) Numéro de dépôt: 06125062.7
(22) Date de dépôt: 30.11.2006
(51) Int. Cl.: H05K 7/18

(54) **Armoire electrique comportant un support de cablage**
Schaltschrank, der eine Verdrahtungshalterung umfasst
Electrical cabinet comprising a wiring bracket

(30) Priorité: 30.11.2005 FR 0512125
(43) Date de publication de la demande: 06.06.2007
(73) Titulaire: LABINAL, 78180 Montigny-le-Bretonneux (FR)
(72) Inventeur: Azemard, Laurent, 34070 Montpellier (FR)
(74) Mandataire: Balesta, Pierre

(56) Documents cités:
- CH-A- 359 166
- CH-A- 668 155
- DE-B1- 2 713 701
- FR-A- 2 092 413
- US-A1- 2005 115 152

## Description

La présente invention concerne une armoire électrique destinée au câblage et au maintien d'équipements électriques.

Plus précisément, l'invention concerne une armoire électrique comprenant:
- un meuble apte à recevoir une pluralité d'équipements électriques,
- une pluralité de faisceaux de câbles électriques fixés à une face du meuble pour la connexion électrique desdits équipements électriques.

De telles armoires électriques sont déjà connues de l'état de la technique, en particulier dans le domaine de l'aéronautique où l'électronique a une place prédominante, mais aussi dans US 2005/0115152.

Par meuble, on entend tout type de structure d'accueil apte à recevoir une pluralité d'équipements électriques.

Dans ce domaine particulier, auquel n'est absolument pas limitée l'invention, les aéronefs, tels des avions ou des hélicoptères par exemple, comportent de nombreux équipements électriques ou électroniques devant être reliés en particulier aux organes de commande ou à des capteurs.

Dans les appareils volants, pour des raisons de sécurité, le réseau électrique est le plus souvent redondant. Cela signifie que le nombre d'équipements électriques et de câbles électriques est doublé, de telle sorte que si, par exemple, un équipement électrique tombe en panne, alors un second appareil identique est prévu pour fonctionner à la place de celui qui est tombé en panne.

On comprend donc que le réseau électrique d'un aéronef comporte de très nombreux câbles électriques.

Dans la pratique, ceux-ci sont le plus souvent regroupés par faisceaux, chacun des faisceaux pouvant correspondre à un type de signal particulier.

L'opération de câblage est l'opération qui consiste généralement à regrouper les câbles électriques par faisceaux, à fixer ces faisceaux à la face du meuble selon une disposition très particulière appelée « routes » ou « chemins de câbles », puis à connecter les différents câbles aux équipements électriques.

Une des étapes les plus longues et délicates est la fixation des faisceaux de câbles à la face du meuble selon les chemins de câbles.

Cette étape demande beaucoup de temps car les faisceaux de câbles doivent être fixés à la main par des opérateurs.

En général, pour un avion neuf, le meuble est câblé en atelier, puis, une fois terminé et testé, l'ensemble formé par le meuble et les faisceaux de câbles est installé dans l'avion lors de l'assemblage de celui-ci.

On comprend que cette opération de câblage nécessite la présence du meuble nu, ce qui en l'espèce pose le problème de la disponibilité du meuble.

Dans le cas d'une réparation mineure d'un avion, des opérateurs interviennent directement sur les câbles défectueux sans démonter le meuble, tandis que dans le cas d'une réparation majeure, il est nécessaire de remplacer le meuble ensemble avec les faisceaux de câbles, ce qui peut nécessiter de démonter partiellement l'avion pour permettre la sortie du meuble.

Le but de l'invention est de proposer une armoire électrique permettant notamment de pallier aux inconvénients cités ci-dessus.

L'invention atteint son but par le fait que l'armoire comprend en outre un support de câblage comportant des éléments de support croisés sur lesquels des faisceaux de câbles électriques sont assemblés et par le fait que ledit support de câblage comporte des moyens de fixation pour sa fixation à la face du meuble, de façon que lesdits câbles électriques peuvent être assemblés au support de câblage et former avec celui-ci un sous-ensemble avant sa fixation audit meuble.

Grâce à l'invention, on comprend que l'assemblage des câbles électriques au support de câblage peut être réalisée sans le meuble. En particulier, l'étape consistant à former les chemins de câbles, préalablement à la connexion des équipements électriques, peut être réalisée sans le meuble.

Les étapes suivantes de finition, modifications finales, test du câblage peuvent également être réalisées sans le meuble.

Autrement dit, l'invention permet de réaliser l'ensemble de l'opération de câblage en atelier, sans nécessité la présence du meuble et dans des conditions d'ergonomie plus favorables pour les opérateurs. Cela permet ainsi de réduire de manière sensible la durée nécessaire pour réaliser l'opération de câblage.

En outre, comme l'opération de câblage peut être réalisée sans le meuble, cela permet de différer l'installation du câblage lors de la construction de l'avion. Par exemple, grâce à la présente invention, le meuble peut être installé nu sur l'avion ou même être intégré à celui-ci, avant l'opération de câblage.

Cette intégration est particulièrement intéressante car elle permet notamment que le meuble participe à la tenue mécanique de l'aéronef.

Par ailleurs, ce concept de meuble intégré présente l'avantage de pouvoir réduire la masse totale de l'aéronef.

Dans le cas d'une réparation majeure, on comprend que l'invention facilite l'opération de dépose en ce qu'elle nécessite uniquement le démontage du support de câblage, et non pas le changement complet du meuble équipé des faisceaux de câbles, qui peut parfois imposer le démontage d'une partie de l'avion.

Les finitions et modifications finales du câblage, qui étaient auparavant réalisées après l'assemblage sur le meuble, peuvent maintenant être effectuées en totalité sur le support de câblage.

Un autre intérêt est de diminuer les risques de blocage de la réalisation du câblage en cas de retard de livraison du meuble.

En sus des intérêts liés au montage, on comprend que le support de câblage est également aisément démontable et qu'il est possible de dissocier rapidement le meuble et le support de câblage sur lequel sont montés les faisceaux de câbles.

Avantageusement, les éléments de support croisés comportent des traverses sensiblement horizontales et des montants sensiblement verticaux.

Avantageusement, les éléments de support croisés sont disposés dans au moins un plan sensiblement vertical appelé niveau.

Avantageusement, les faisceaux de câbles électriques sont assemblés le long des éléments de support croisés.

De manière préférentielle, les éléments de support servent de guide formant supports pour l'acheminement des faisceaux électriques.

Avantageusement, le meuble comporte une pluralité d'étagères horizontales sur lesquelles sont disposés les équipements électriques et au moins l'une des traverses est disposée au voisinage du plan de l'une des étagères.

On comprend que lorsque le support de câblage est fixé au meuble, le faisceau de câbles, qui est assemblé sur la traverse disposée au voisinage du plan de l'une des étagères, est amené et maintenu à proximité des équipements électriques, ce qui permet de faciliter ensuite la connexion des câbles électriques auxdits équipements.

On appelle étagère associée à une traverse, l'étagère dont le plan est situé au voisinage de la traverse.

De préférence, au moins l'une des traverses comporte au moins un module de masse auquel sont reliées les masses électriques des équipements électriques.

Avantageusement, au moins l'une des traverses comporte au moins une barreau horizontal supportant au moins l'un des faisceaux de câbles électriques.

De préférence, au moins une traverse comporte au moins un barreau horizontal supérieur et au moins un barreau horizontal inférieur, disposés de telle sorte que ledit au moins un barreau supérieur est dans un plan horizontal situé légèrement au dessus du plan de ladite l'étagère, et ledit au moins un barreau inférieur est dans un plan horizontal situé légèrement en dessous du plan de ladite l'étagère.

Toujours de préférence, chacun des barreaux est apte à supporter un faisceau de câbles que l'on peut connecter avec l'un des équipements électriques situé sur l'étagère associée et/ou avec l'un des équipements électriques situé sous l'étagère associée.

Avantageusement, au moins l'une des traverses comporte deux paires de barreaux disposées dans deux niveaux distincts.

De préférence, chaque paire de barreaux comporte un barreau supérieur et un barreau inférieur.

Selon une variante, les barreaux supérieurs et inférieurs sont disposés substantiellement dans deux plans horizontaux distincts.

Avantageusement, au moins l'un des barreaux est localement arqué, de manière à pouvoir faire passer au moins l'un des faisceaux de câbles d'un barreau d'un premier niveau vers un barreau d'un deuxième niveau.

De préférence, ledit barreau présente une portion arquée qui s'étend dans un plan substantiellement horizontal.

On comprend que la déformation locale du barreau permet de diminuer localement la distance séparant deux barreaux contenus dans un même plan horizontal, par exemple deux barreaux supérieurs ou deux barreaux inférieurs, si bien que le faisceau de câbles précité peut passer facilement du barreau disposé dans un premier niveau à un barreau disposé dans un deuxième niveau, distinct du premier, tout en restant guidé et maintenu.

De manière préférentielle, deux barreaux supérieurs, ou inférieurs, situés substantiellement dans un même plan horizontal sont tous deux localement arqués, de telle sorte que leurs portions arquées respectives sont en regard l'une de l'autre, ce qui permet encore de diminuer la distance séparant les deux barreaux.

Naturellement, on peut également prévoir que l'un des barreaux présente une portion arquée s'étendant dans un plan substantiellement vertical, ou bien incliné de manière à faciliter le passage d'un faisceau de câbles entre des barreaux supérieur et inférieur disposés dans un même niveau.

Avantageusement, au voisinage de l'intersection de l'un des barreaux et d'un montant, ledit barreau est localement arqué.

Dès lors, on comprend que grâce à la présente invention, le faisceau de câbles supporté par le barreau est localement dévié au voisinage du montant, de manière à contourner le faisceau électrique supporté par le montant.

Selon une variante, le montant peut être localement arqué pour s'éloigner du faisceau supporté par le barreau.

Selon une autre variante, au moins l'une des traverses comporte en outre un longeron apte à supporter au moins l'un des faisceaux de câbles.

De préférence, le longeron présente une partie supérieure et une partie inférieure, chacune de ces parties portant un des faisceaux de câbles.

Selon une autre variante, le longeron comporte en outre des barreaux aptes à supporter des faisceaux de câbles.

Avantageusement, la distance entre deux éléments de support est dimensionnée pour respecter les ségrégations entre les faisceaux de câbles électriques assemblés sur ces deux éléments de support.

De manière connue, le câblage d'une armoire électrique utilisée dans le domaine particulier de l'aéronautique, doit respecter les règles de ségrégation de la réglementation aéronautique.

Par ségrégation, on entend l'action de séparer deux faisceaux de câbles, d'une distance suffisante en vue de s'affranchir des problèmes de diaphonie et de perturbation électromagnétique, d'une part, et pour des raisons de sécurité d'autre part.

La séparation physique des faisceaux permet d'éviter, par exemple, que la surchauffe d'un faisceau n'affecte un faisceau voisin.

En l'espèce, on prévoit avantageusement une distance suffisante entre deux barreaux d'une même traverse. De même on prévoit avantageusement une distance suffisante entre deux barreaux ou longerons de deux traverses différentes, de telle sorte qu'il existe toujours entre deux faisceaux de câbles une distance suffisante pour que les règles de ségrégation soient respectées.

En outre, les règles de ségrégation sont également respectées au voisinage de l'intersection d'un barreau et d'un montant, par le fait que le barreau horizontal ou le montant est localement arqué. En l'espèce, on comprend que le faisceau de câbles supporté par le barreau horizontal et celui qui est supporté par le montant sont toujours suffisamment espacés afin de respecter les règles de ségrégation.

Avantageusement, le support de câblage est métallique.

Il peut être par exemple réalisé en aluminium. Cependant, dans le cas où la conductivité électrique de celui-ci n'est pas nécessaire, il peut avantageusement être réalisé en matériau composite.

De manière préférentielle, le support de câblage est composé de tubes cylindriques, ne comportant pas ou peu d'arêtes de manière à ne pas endommager les faisceaux qu'il supporte, ces tubes étant assemblés entre eux pour former un support compact et rigide.

Lorsque l'armoire électrique selon l'invention est utilisée dans un appareil volant, tel un avion, le support de câble peut être avantageusement relié électriquement à la masse électrique de l'avion. Dans ce cas, les masses électriques des équipements électriques, reliées de préférence aux modules de masse, sont en liaison électrique avec la masse électrique de l'avion, permettant notamment l'écoulement des charges électrostatiques et des éventuels courants induits par la foudre.

Le support de câblage assure donc la continuité électrique de la masse, ce qui est particulièrement intéressant lorsque le meuble est avantageusement réalisé dans un matériau non conducteur, tel un matériau composite.

Avantageusement, les équipements électriques sont disposés dans des supports métalliques aptes à être reliés électriquement au support de câblage.

De tels supports métalliques sont déjà connus dans le domaine de l'aéronautique.

On comprend que l'intérêt de relier électriquement les supports métalliques au support de câblage est de permettre la continuité électrique entre les équipements électriques et la masse électrique de l'avion.

L'invention concerne aussi un aéronef comportant une armoire selon la présente invention, dans lequel l'armoire comporte un meuble intégré à une structure principale de l'aéronef.

De manière préférentielle, la structure principale de l'aéronef correspond à l'ossature métallique de l'aéronef.

L'invention concerne également un support de câblage pour une armoire électrique selon l'invention, sur lequel des faisceaux de câbles électriques sont assemblés, ledit support de câblage comportant des moyens de fixation pour sa fixation à la face d'un meuble, lesdits câbles électriques pouvant être assemblé au support de câblage avant sa fixation au meuble.

L'invention concerne aussi un procédé de câblage d'une armoire électrique, dans lequel on assemble les faisceaux de câbles sur le support de câblage, on fixe le support de câblage au meuble et on fixe les connecteurs aux supports.

L'invention sera mieux comprise et ses avantages apparaîtront mieux à la lecture de la description détaillée qui suit, de trois modes de réalisation indiqués à titre d'exemples non limitatifs. La description se réfère aux dessins annexés sur lesquels :
- la figure **1** est une vue en perspective de l'armoire électrique selon un premier mode de réalisation de l'invention, dans laquelle les faisceaux de câbles ni les équipements électriques n'ont pas été représentés ;
- la figure **2** est une vue en perspective du support de câblage de l'armoire électrique selon un premier mode de réalisation de l'invention ;
- la figure **3** est une vue en perspective du support de câblage de l'armoire électrique sur lequel sont assemblés les faisceaux de câble, selon un premier mode de réalisation de l'invention ;
- la figure **4** est une vue de côté en coupe du support de câblage de la figure **3****,** sur laquelle est représentée une connexion de l'un des équipements électriques ;
- la figure **5** est une vue de dessus du support de câblage de la figure **3** **;**
- la figure **6** est une vue en perspective de l'armoire électrique selon un deuxième mode de réalisation de l'invention, dans laquelle les faisceaux de câbles n'ont pas été représentés ;
- la figure **7** est une vue en perspective du support de câblage de l'armoire électrique selon un deuxième mode de réalisation de l'invention ;
- la figure **8** est une vue en perspective du support de câblage de l'armoire électrique sur lequel sont assemblés les faisceaux de câble, selon un deuxième mode de réalisation de l'invention ;
- la figure **9** est une vue de dessus du support de câblage de l'armoire électrique sur lequel sont assemblés les faisceaux de câble, selon un deuxième mode de réalisation de l'invention ;
- la figure **10** est une vue de côté en coupe A-A du support de câblage de la figure **9** **;**
- la figure **11** est une vue en perspective de l'armoire électrique selon un troisième mode de réalisation de l'invention, dans laquelle les équipements électriques n'ont pas été représentés ;
- la figure **12** est une vue en perspective du support de câblage de l'armoire électrique selon un troisième mode de réalisation de l'invention, où une partie des faisceaux électriques est représentée ;
- la figure **13** est une vue de dessus du support de câblage de la figure **12** **;** et
- la figure **14** est une vue de face du support de câblage de la figure **12** **;**
- la figure **15** est une vue de côté en coupe A-A du support de câblage de la figure **14** qui représente de façon détaillée la ségrégation entre les faisceaux de câbles de deux traverses voisines du support de câblage.

L'armoire électrique conforme à l'invention est principalement destinée à être utilisée dans un aéronef tel un avion par exemple. Toutefois, cela ne constitue pas une limitation et l'armoire électrique selon l'invention peut très bien être utilisée dans des domaines dans lesquels il est nécessaire de connecter des équipements électriques à des faisceaux de câbles électriques.

Dans la description détaillée qui suit, on va décrire trois modes de réalisation de l'armoire électrique selon l'invention.

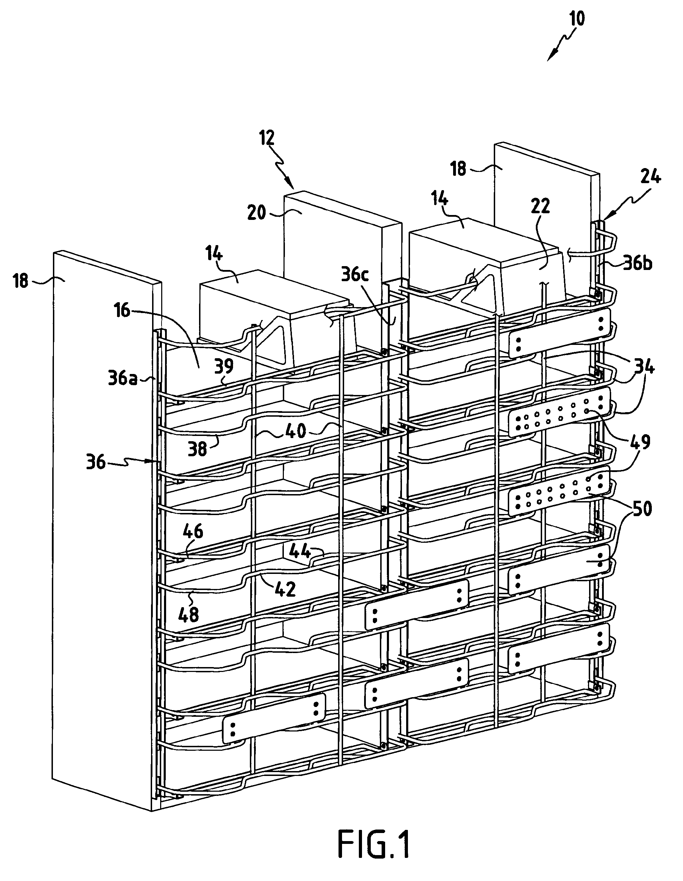

Les figures **1** à **5** représentent un premier mode de réalisation de l'armoire électrique selon l'invention.

La figure **1** représente une armoire électrique **10** comportant un meuble **12** destinée à recevoir une pluralité d'équipements électriques **14.** De tels équipements **14** sont déjà connus dans le domaine de l'aéronautique. Il peut s'agir par exemple de calculateurs, de radios ou tout autre type d'équipements électriques ou électroniques.

Le meuble **12** est de préférence un meuble à étagères qui comporte dans cet exemple six étagères **16** s'étendant chacune dans un plan horizontal.

Les étagères sont maintenues par deux montants latéraux **18** et un montant central **20,** qui s'étendent verticalement.

Chacune des étagères **16** présente une profondeur suffisante pour recevoir les équipements électriques **14.**

L'armoire électrique conforme à l'invention n'est pas du tout limitée à l'utilisation d'un meuble à étagères. Il est tout à fait possible d'utiliser d'autres types de meuble ou de structure d'accueil aptes à recevoir des équipements électriques, sans sortir du cadre de la présente invention.

Comme on le constate sur la figure **1****,** le montant central **20** constitue un plan de symétrie pour le meuble à étagères **12.**

Par conséquent, chacune des étagères **16** est symétrique par rapport au plan de symétrie du meuble à étagères **12,** définissant ainsi deux parties d'étagère.

De manière préférentielle, ces deux parties d'étagère reçoivent des équipements électriques identiques ou complémentaires, de manière à assurer la redondance des équipements électriques de l'avion.

Comme on l'a déjà indiqué, la redondance est une spécificité du domaine de l'aéronautique dont l'objectif est de maximiser la sécurité à bord des aéronefs. L'idée est que si l'un des équipements électriques tombe en panne, il est prévu un second équipement électrique identique au premier apte à se substituer à l'équipement électrique défaillant. En l'espèce, chacune des parties d'étagère reçoit l'un des deux équipements précités.

L'armoire électrique selon l'invention comporte donc deux sous-ensembles d'équipements électriques de préférence mais pas nécessairement identiques.

De manière connue, les équipements électriques **14** sont de préférence insérés et maintenus dans des supports métalliques **22** fixés aux étagères. Comme support métallique **22,** on peut utiliser par exemple un support du type ARINC.

Généralement, chacun des équipements électriques **14** est connecté à d'autres appareillages, par exemple à d'autres équipements électriques, à des organes de commandes ou à des capteurs, par l'intermédiaire de câbles électriques véhiculant divers signaux.

Comme les équipements électriques sont redondants, on comprend qu'il est nécessaire que les câbles électriques soient également redondants.

Conformément à la présente invention, ces câbles électriques sont assemblés sur un support de câblage **24** apte à être fixé à une face du meuble.

De manière préférentielle, les câbles électriques sont tout d'abord assemblés au support de câblage **24,** avant que ce dernier ne soit fixé au meuble à étagères **12.** Toutefois, on peut également assembler les câbles après la fixation du support de câblage au meuble **12.**

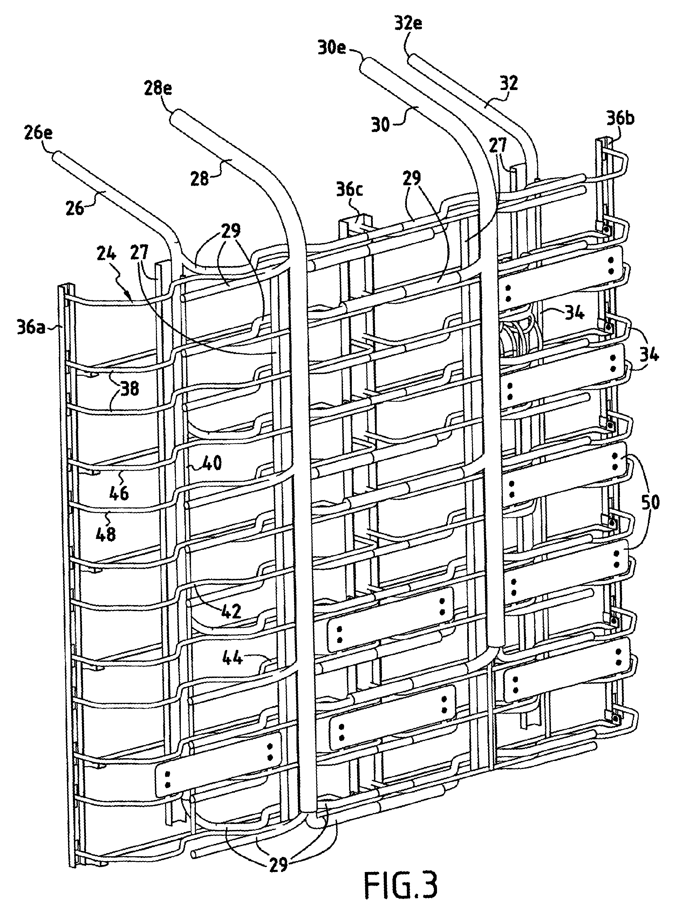

Dans l'exemple représenté sur la figure **3****,** chacun des équipements électriques **14** reçoit deux types de signaux, portant les références **S** et **M.** En raison de la redondance, on comprend qu'il existe deux séries **1S, 2S** de câbles électriques qui véhiculent les signaux de type **S** et deux séries de câbles électriques **1M, 2M** qui véhiculent les signaux de type **M.**

Cet exemple représente donc quatre séries de signaux que l'on appelle également « routes ».

Bien évidemment, l'invention n'est pas limitée à quatre routes et l'on peut très bien prévoir six, huit ou davantage de routes.

Les câbles électriques d'une même route sont de préférence regroupés par faisceaux présentant une section sensiblement circulaire.

Comme on l'a représenté sur la figure **3****,** quatre faisceaux de câbles principaux **26, 28, 30, 32** correspondant respectivement aux routes **1S, 1M, 2M** et **2S** sont amenées depuis une partie située au dessus du support de câblage. Les extrémités amont **26e, 28e, 30e** et **32e** des faisceaux de câbles **26, 28, 30, 32** sont aptes à être connectées au circuit électrique de l'avion par l'intermédiaire d'un connecteur non représenté ici.

De manière préférentielle, ces faisceaux de câbles principaux **26, 28, 30, 32** sont fixés au support de câblage de telle manière qu'ils s'étendent selon des directions verticales.

Comme on le voit sur la figure **3****,** les faisceaux de câbles principaux se divisent en des faisceaux de câbles secondaires **29** qui s'étendent le long des traverses, au voisinage des équipements électriques.

Ces faisceaux secondaires peuvent aussi se diviser à nouveau, mais cela n'est pas représenté ici.

Ensuite, les équipements électriques sont connectés de manière connue aux câbles électriques provenant des faisceaux de câbles situés dans leur voisinage.

On va maintenant décrire plus en détail le support de câblage **24** de l'armoire électrique dans son premier mode de réalisation, avant de décrire comment les faisceaux de câbles sont assemblés à ce support de câblage **24.**

Le support de câblage **24** représenté sur les figures **1** à **5** se présente sous la forme d'une grille métallique comportant des éléments de support croisés **34,** en l'espèce des traverses **38** sensiblement horizontales et des montants **40** sensiblement verticaux.

Comme on le voit sur les figures 1, 6 et 11, le support de câblage, lorsqu'il est fixé à la face du meuble, recouvre sensiblement la face du meuble en s'étendant sensiblement dans un plan parallèle à ladite face.

De manière préférentielle, le support de câblage **24** présente sensiblement les mêmes dimensions en hauteur et en largeur que le meuble à étagères **12.**

Les traverses **38** sont maintenues à chacune de leurs extrémités par une barre verticale **36.** En l'espèce, le support de câblage **24** comporte trois barres verticales **36,** à savoir deux barres verticales **36a, 36b** situées aux extrémités du support de câblage **24** et une barre verticale centrale **36c.**

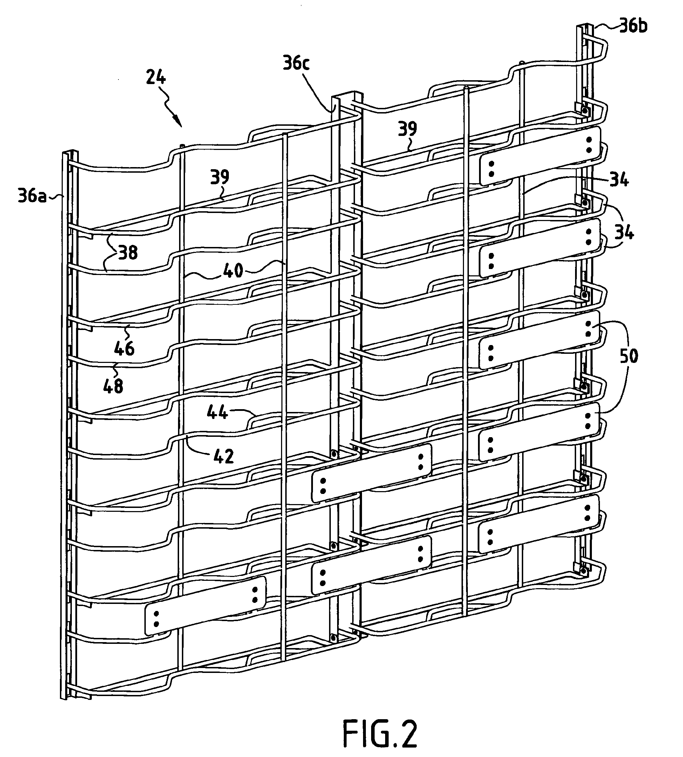

Comme on le constate sur les figures **1** et **2****,** le support de câblage présente le même plan de symétrie que celui du meuble à étagères, à savoir un plan de symétrie verticale passant par la barre verticale centrale **36c.**

Comme on le voit sur la figure **1****,** les barres verticales **36** constituent les moyens de fixation du support de câblage **24** au meuble à étagères **12.** Comme on le comprend, les barres verticales **36** sont fixées aux montants **18, 20** du meuble à étagères **12.**

Dans ce mode de réalisation, les traverses **38** et les montants **40** se présentent sous la forme de barreaux cylindriques métalliques soudés entre eux.

De manière préférentielle, le support de câblage **24** comporte en outre des montants **27** verticaux formant cloison de protection afin de protéger les câbles principaux en cas d'incendie d'un équipement **14** situé à leur proximité.

Toujours de manière préférentielle, on prévoit autant de montants verticaux **27** formant cloison de protection anti-feu que de câbles principaux.

Comme on le constate sur les figures **1** à **5****,** ces traverses **38** comportent des portions arquées **42,** chacune d'entre elles étant sensiblement contenue dans un plan horizontal.

Les traverses **38** peuvent en outre comporter des portions de barreaux arquées **44,** également contenues dans des plans horizontaux, dont la fonction sera explicitée par la suite.

Selon l'invention, au moins l'une des traverses **38** est disposée au voisinage du plan de l'une des étagères **16.**

Dans l'exemple représenté ici, les traverses **38** comportent un barreau supérieur **46** et un barreau inférieur **48,** disposés de telle sorte que le barreau supérieur **46** est contenu dans un plan horizontal situé légèrement au dessus du plan de ladite l'étagère **16,** et le barreau inférieur **48** est contenu dans un plan horizontal situé légèrement en dessous du plan de ladite l'étagère **16.**

Toutefois, en ce qui concerne l'étagère située au pied du meuble **12** et celle située au sommet du meuble, on constate qu'un seul barreau supérieur s'étend au voisinage de ces étagères.

Le support de câblage comporte en outre une pluralité de modules de masse **49** auxquels sont reliées les masses électriques des équipements électriques **14.** De manière préférentielle, les modules de masses sont montés sur des platines **50** fixées directement au support de câblage **24.**

Les platines **50** peuvent également servir de support à tout autre composant électrique, telles des barrettes de raccordement.

Comme on le constate sur les figures **1** à **3****,** chacune des platines **50** est fixée entre le barreau supérieur **46** et le barreau inférieur **48** de l'une des traverses **38.**

Cette disposition permet de ne pas obstruer l'espace entre deux traverses **38** voisines, afin de permettre aux opérateurs de connecter électriquement les faisceaux de câbles aux supports **22.**

En outre, on prévoit autant de montants **40** que de routes. En l'espèce, le support de câblage compte deux paires de montants **40,** qui s'étendent sensiblement sur toute la hauteur du support de câblage **24.**

Vue dans le sens de la largeur du support de câblage **24,** chacune des paires de montants **40** est de préférence disposée entre une barre verticale d'extrémité **36a** ou **36b** et la barre verticale centrale **36c.**

En outre, les traverses **38** comportent des lames métalliques **39** s'étendant horizontalement entre les barres verticales. En l'espèce, il est prévu autant de lames métalliques **39** que d'étagères **16.** Les lames métalliques **39** sont destinées à assurer la continuité électrique entre les supports métalliques **22** et le support de câblage **24,** en vue d'assurer la mise à la masse des équipements.

A l'aide de la figure **3****,** on va maintenant décrire de quelle manière les faisceaux de câbles électriques **26, 28, 29, 30, 32** sont assemblés au support de câblage **24** décrit ci-dessus.

Les faisceaux de câbles principaux **26, 28, 30** et **32** sont préférentiellement assemblés aux quatre montants **40** du support de câblage **24,** et les faisceaux de câbles secondaires **29** sont quant à eux fixés aux traverses **38** de manière à s'étendre horizontalement sur sensiblement toute la largeur du support de câblage **24.**

De manière préférentielle et pour des raisons explicitées ci-dessous, chacun des barreaux horizontaux **46, 48** ne supporte, dans une même portion, qu'un unique faisceau de câbles secondaire **29.**

Comme on le voit sur la figure **3****,** il n'est pas nécessaire que tous les faisceaux de câbles principaux s'étendent sur toute la hauteur du support de câblage **24.**

On va maintenant expliciter la fonction des portions arquées **42, 44** décrites ci-dessus.

Comme on l'a déjà mentionné, l'armoire électrique **10** selon l'invention est conçue pour respecter la règlementation en matière de ségrégation.

Cela se traduit par le fait qu'il est nécessaire de respecter une distance minimale entre deux faisceaux de câbles différents, de sorte qu'il ne se produise pas d'interférences entre les signaux véhiculés par ces deux faisceaux de câble.

Dès lors, on comprend que les portions arquées **42, 44** servent à dévier localement l'un des faisceaux de câble secondaire **29** lorsque celui-ci en croise un autre.

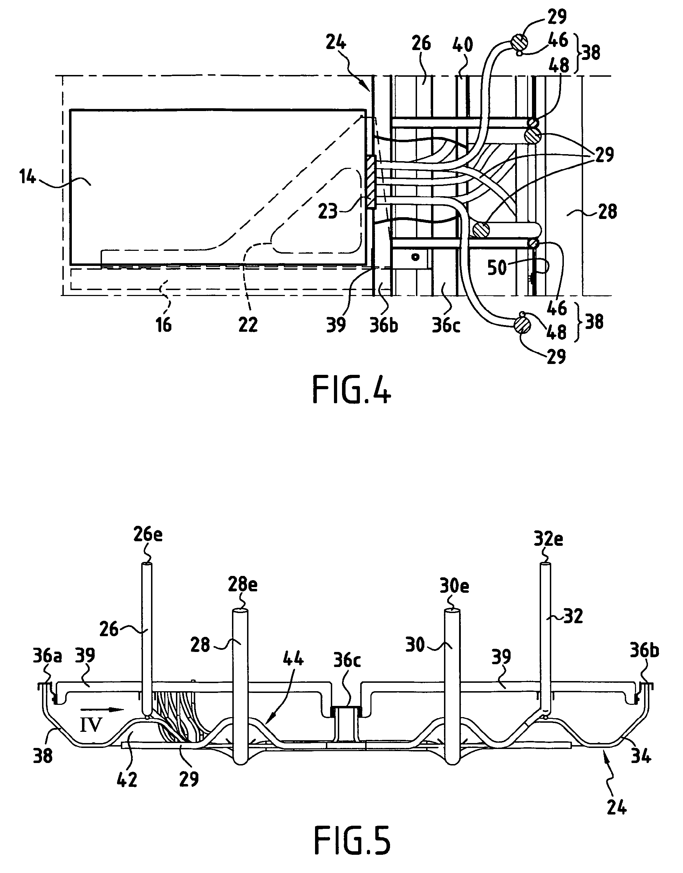

Par exemple, on peut prévoir qu'au voisinage de l'intersection de l'un des barreaux **46, 48** et d'un montant **40,** ledit barreau **46, 48** soit localement arqué, de telle manière que le faisceau de câble secondaire **29** disposé horizontalement est localement dévié pour éviter le faisceau de câble principal **26, 28, 30, 32** qu'il croise. Une telle déviation est particulièrement visible sur la figure **5****.**

Dès lors, on comprend qu'une distance minimale peut être respectée entre les deux faisceaux de câbles.

En outre, il est prévu que la distance entre les barreaux horizontaux supérieur **46** et inférieur **48** d'une même traverse **38** soit suffisamment grande pour éloigner les faisceaux de câbles en vue de respecter les règles de ségrégation.

Dans le même ordre d'idée, les montants **40** sont suffisamment éloignés entre eux, de telle sorte que les faisceaux de câbles principaux **26, 28, 30, 32** ne s'influencent pas réciproquement.

Sur la figure **4****,** on a schématisé la connexion de l'un des équipements électriques **14.** Cet équipement électrique **14** est connecté à chacune des quatre routes **1S, 1M, 2S** et **2M.** En l'espèce, quatre câbles électriques sont issus de quatre faisceaux secondaires **29** supportés d'une part par les barreaux **46** et **48** de la traverse **38** disposée au voisinage du plan de l'étagère **16** supportant l'appareil **14,** et d'autre part par les barreaux **46** et **48** de la traverse immédiatement supérieure.

Comme on le voit sur cette figure, les câbles électriques sont connectés à l'équipement électrique **14** par l'intermédiaire d'un connecteur **23** relié au câblage, que l'on fixe à l'arrière du support métallique **22** lors de l'assemblage du support de câblage **24** sur le meuble à étagères **12.**

De manière connue, l'équipement électrique **14** comporte un connecteur apte à être enfiché dans le connecteur du support métallique **22.**

De manière préférentielle, la distance séparant deux barreaux de deux traverses voisines est suffisamment grande pour qu'un opérateur puisse fixer le connecteur **23** audit support métallique **22,** et intervenir manuellement sur les câbles électriques si nécessaire.

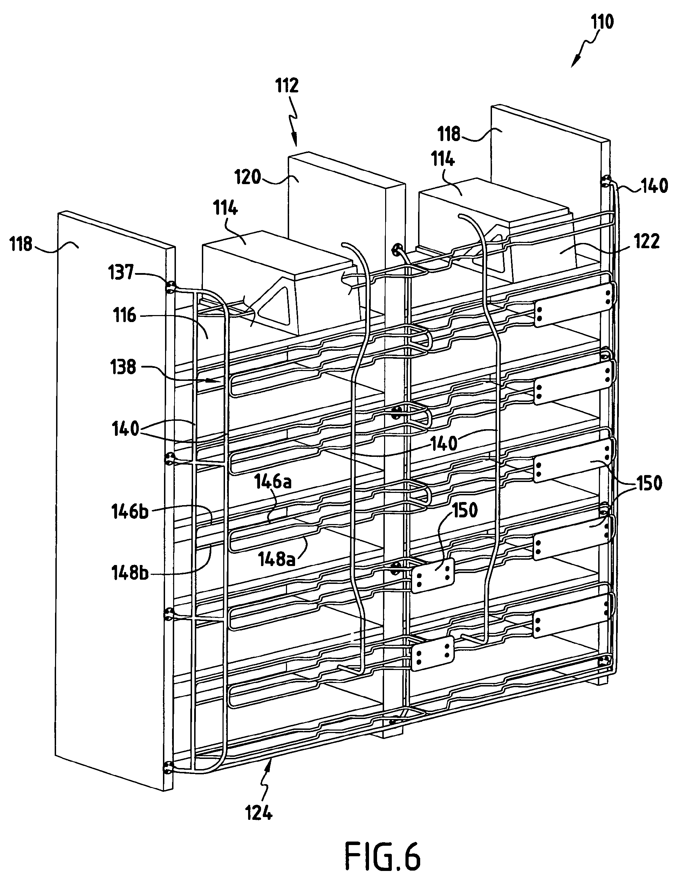

A l'aide des figures **6** à **10****,** on va maintenant décrire un deuxième mode de réalisation de l'armoire électrique selon l'invention.

Le deuxième mode de réalisation comporte certains éléments déjà décrits dans le premier mode de réalisation. Ces éléments identiques ont pour référence numérique, celle de l'élément décrit dans le premier mode de réalisation augmenté de la valeur cent.

Dans ce deuxième mode de réalisation, le meuble **112** de l'armoire **110** est le même que celui utilisé dans le premier mode de réalisation. Par contre, l'armoire électrique **110** est prévue pour recevoir des équipements électriques **114** nécessitant trois signaux différents, c'est-à-dire que le support de câblage supporte six routes en raison de la redondance.

Par souci de lisibilité, les faisceaux de câbles n'ont pas été représentés sur la figure **6****.**

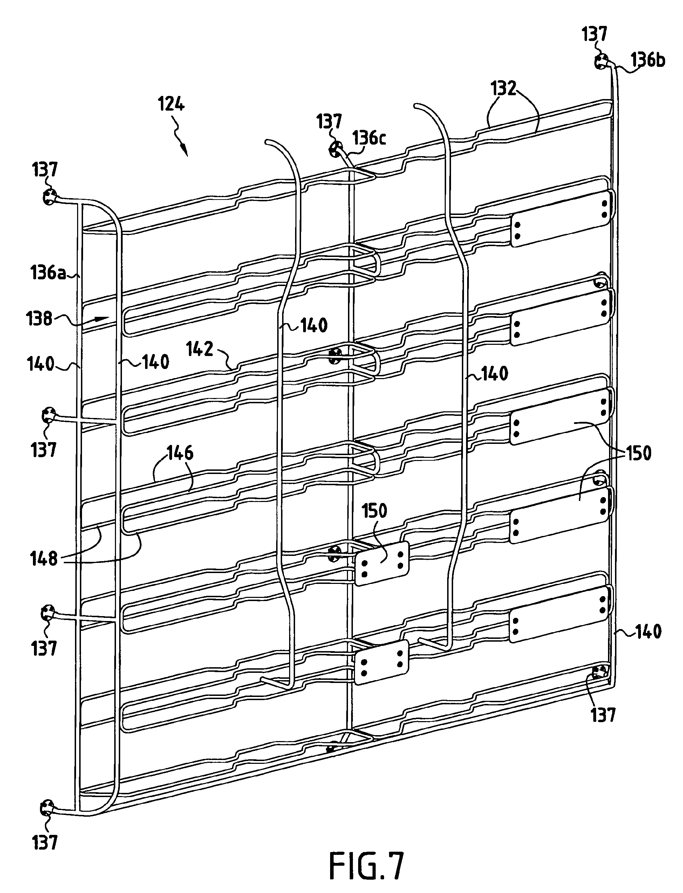

La figure **7** représente le support de câblage **124** du deuxième mode de réalisation de l'armoire électrique **110** conforme à l'invention.

Le support de câblage **124** présente également la forme d'une grille comportant des éléments de support croisés sous la forme de montants **140** et de traverses **138.**

Dans l'exemple représenté, le support de câblage **124** comporte six montants **140,** chacune des extrémités latérales du support de câblage **124** comportant deux montants **140.**

Dans ce mode de réalisation, des barres verticales d'extrémité **136a** et **136b** sont constituées par les montants **140** situés à ces extrémités.

Comme on le voit sur les figures **6** et **7****,** les moyens de fixation du support de câblage **124** au meuble à étagères **112** sont constitués par des pattes de fixation **137** s'étendant depuis les montants **140** qui sont situés aux extrémités du support de câblage **124,** et depuis un montant central situé dans le plan de symétrie du support de câblage **124.**

Sur l'exemple représenté, le support de câblage **124** comporte sept traverses **138** comportant des barreaux sensiblement horizontaux.

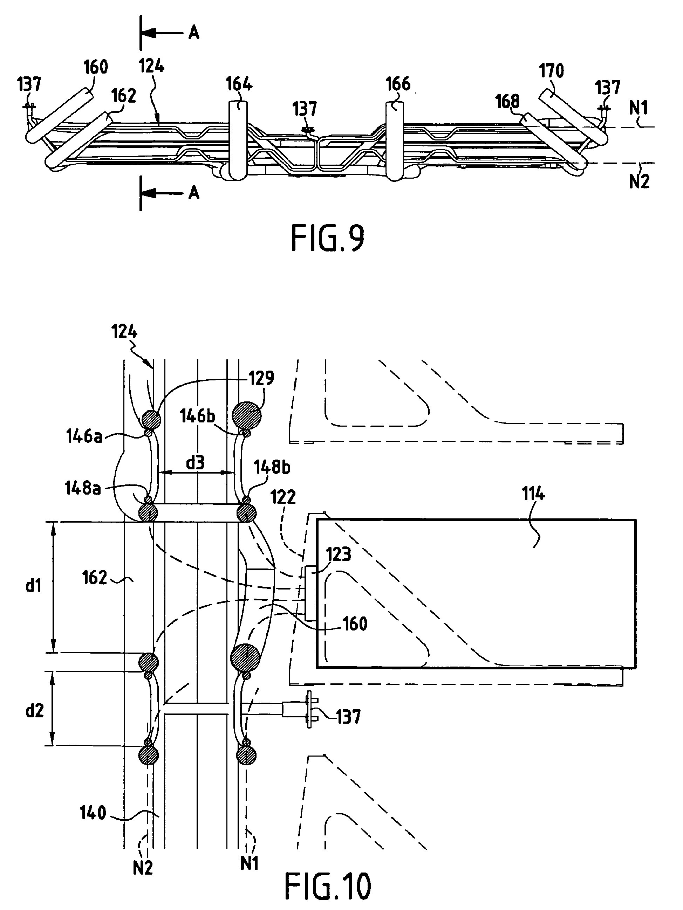

Les barreaux **146, 148** sont contenus dans deux plans verticaux **N1, N2** distincts, appelée également niveaux visibles sur la figure **9****.** On distinguera un premier niveau **N1** d'un deuxième niveau **N2,** le premier niveau **N1** étant celui qui est situé le plus près du meuble à étagères **112.**

Mis à part les traverses **138** situées aux extrémités inférieure et supérieure du support de câblage **124,** chaque traverse **138** comporte deux paires de barreaux horizontaux, chacune des paires comprenant un barreau supérieur **146** et un barreau inférieur **148.**

On constate également que les deux barreaux supérieurs **146a, 146b** d'une même traverse sont situés sensiblement dans un même plan horizontal. Il en est de même des deux barreaux inférieurs **148a, 148b** de ladite traverse **138.**

Comme on le constate sur la figure **7****,** les barreaux comportent également des portions arquées **142.**

Comme on le voit plus particulièrement sur la figure **9****,** les deux barreaux supérieurs **146a, 146b** d'une des traverses **138** comportent chacun une portion arquée s'étendant dans un plan horizontal ces deux portions arquées **142** étant disposées en vis-à-vis de telle sorte que la distance entre les deux barreaux **146a, 146b** est localement réduite. Il en est de même pour les deux barreaux inférieurs **148a, 148b.** L'intérêt de cette réduction locale de distance sera explicité par la suite.

Le support de câblage **124** comporte également des platines **150** fixés entre les barreaux supérieurs **146a** et inférieurs **148a** du deuxième niveau **N2** de l'une des traverses **138.** Cette platine **150** est destinée à recevoir des modules de masse tels décrits dans le premier mode de réalisation, ou tout autre composant électrique

La traverse située à l'extrémité inférieure du support de câblage **124** comporte uniquement une paire de barreaux supérieurs **146a, 146b,** tandis que la traverse **138** située à l'extrémité supérieure du support de câblage **124** comporte uniquement une paire de barreaux inférieurs **148a, 148b.**

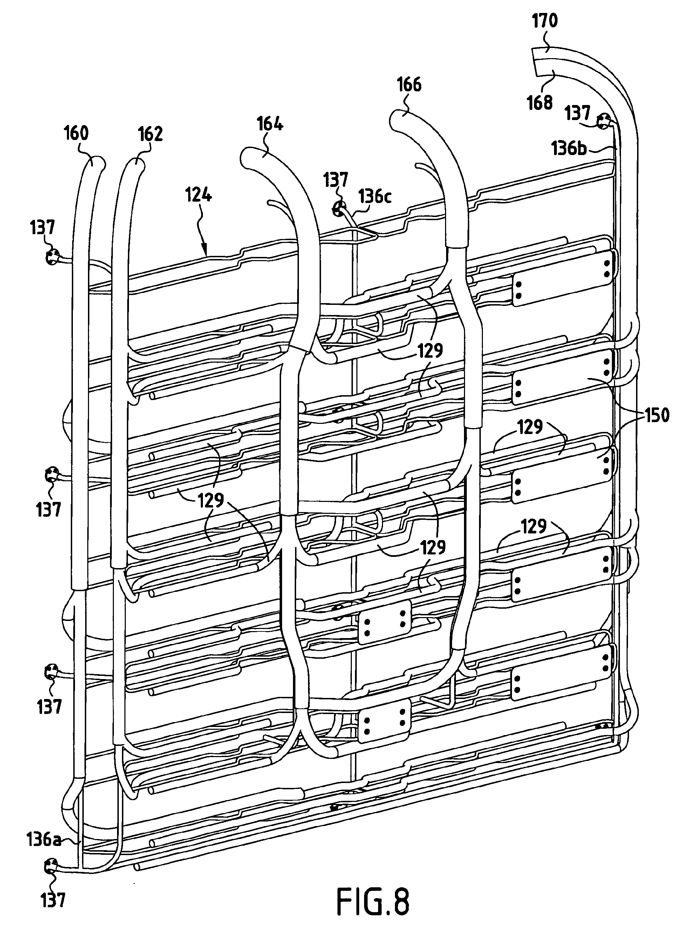

À l'aide des figures **8** à **10****,** on va maintenant décrire l'assemblage des faisceaux de câble au support de câblage **124** de l'armoire électrique **110** selon le deuxième mode de réalisation.

Les six routes de signaux **160, 162, 164, 166, 168** et **170** sont amenées via des faisceaux de câbles principaux depuis la partie supérieure de l'armoire électrique **110.**

Comme dans le premier mode de réalisation, chacun des faisceaux de câbles principaux est supporté par l'un des montants **140.** Ces faisceaux principaux se divisent en faisceaux de câbles secondaires **129** s'étendant horizontalement le long des barreaux **146, 148.**

Plus précisément, les barreaux **146, 148** supportent et guident les faisceaux de câbles secondaires **129.**

Des portions arquées **142** détaillées ci-dessus permettent d'accompagner le faisceau de câble secondaire lors d'un changement de niveau **N1, N2.**

Il en effet prévu que les faisceaux de câbles secondaires puissent passer d'un barreau du premier niveau **N1** vers un barreau d'un deuxième niveau **N2,** et réciproquement.

De manière préférentielle, lorsqu'un des faisceaux de câble passe d'un niveau à l'autre, celui-ci reste sensiblement dans le même plan horizontal.

On pourrait toutefois concevoir des portions arquées **142** qui ne soient pas situées dans des plans horizontaux et qui permettent d'accompagner un faisceau de câbles secondaires depuis un barreau inférieur **148** vers un barreau supérieur **146** (ou l'inverse) d'une même traverse **138.**

Un des intérêts du changement de niveau est d'empêcher la collision entre deux faisceaux de câbles secondaires **129** se trouvant sur le même barreau. En raison du grand nombre de faisceaux de câbles **129,** il est tout à fait possible que deux faisceaux de câbles secondaires **129** soient supportés, dans des portions différentes, par le même barreau, en l'occurrence à chacune de ses extrémités. Ce cas de figure est notamment visible sur la figure **8****.**

On comprend que ces faisceaux de câbles ne doivent pas se croiser sur le même barreau **146, 148.** On prévoit donc que l'un des deux faisceaux de câbles secondaires précités soit dévié vers un autre niveau **N1, N2** de telle sorte que les deux faisceaux de câbles secondaires **129** soient toujours suffisamment éloignés l'un de l'autre.

En outre, tout comme dans le premier mode de réalisation, un faisceau de câbles secondaire **129** peut-être localement dévié grâce aux portions arquées **142** de manière à éviter un des faisceaux de câbles principaux **160, 162, 164, 166, 168** et **170** s'étendant verticalement.

Les portions arquées **142** sont notamment visibles sur la figure **9** représentant le support de câblage **124** vu de dessus.

La figure **10** représente quant à elle une vue de côté en coupe **AA** du support de câblage **124.** Les supports métalliques **122** du type ARINC destinée à accueillir les équipements électriques **114** ont été représentés en traits pointillés.

Comme on le voit sur cet exemple, les barreaux supérieurs et inférieurs d'une même traverse **138** sont espacés d'une distance **d2** d'environ 80 mm.

La distance **d3** entre deux niveaux **N1, N2** est d'environ 85 mm.

En outre, les barreaux horizontaux de deux traverses voisines sont espacés d'une distance **d1** d'au moins 140 mm, ce qui permet à un opérateur de pouvoir fixer le connecteur **123** au support métallique **122,** et intervenir manuellement, si nécessaire, sur les câbles électriques, entre deux traverses voisines.

Ces trois valeurs de distances **d1, d2** et **d3** sont données à titre d'illustration et ne constitue en aucun cas une limitation.

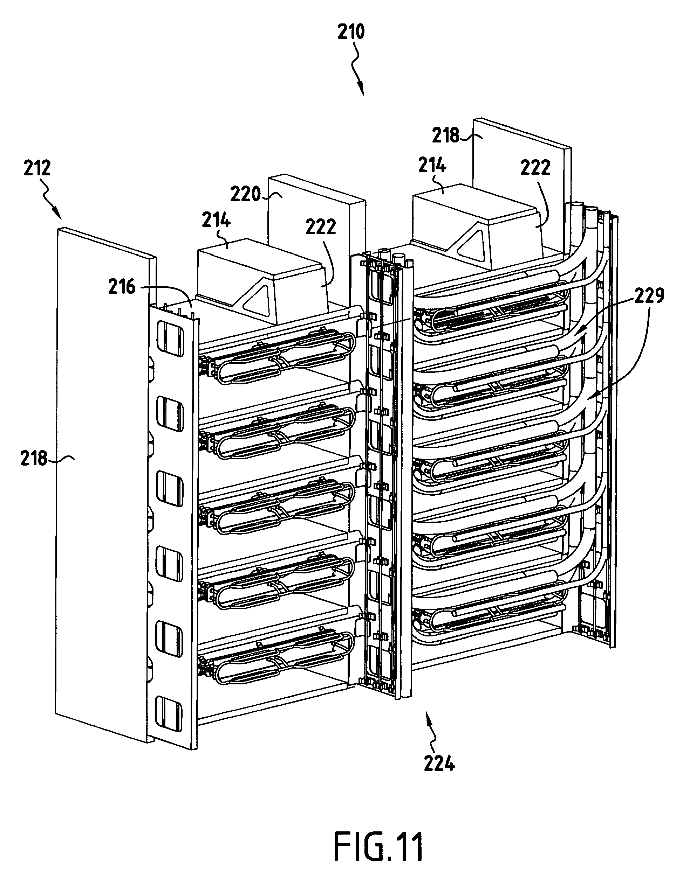

À l'aide des figures **11** à **15****,** on va maintenant décrire un troisième mode de réalisation de l'armoire électrique selon l'invention.

Le troisième mode de réalisation comporte certains éléments déjà décrits dans les deux premiers modes de réalisation. Ces éléments identiques ont pour référence numérique, celle de l'élément décrit dans le premier mode de réalisation augmenté de la valeur deux cent.

La figure **11** représente l'armoire électrique **210** selon le troisième mode de réalisation de l'invention.

On retrouve le meuble à étagères **212,** les supports métalliques **222** et les équipements électriques **214** déjà décrits pour les deux premiers modes de réalisation.

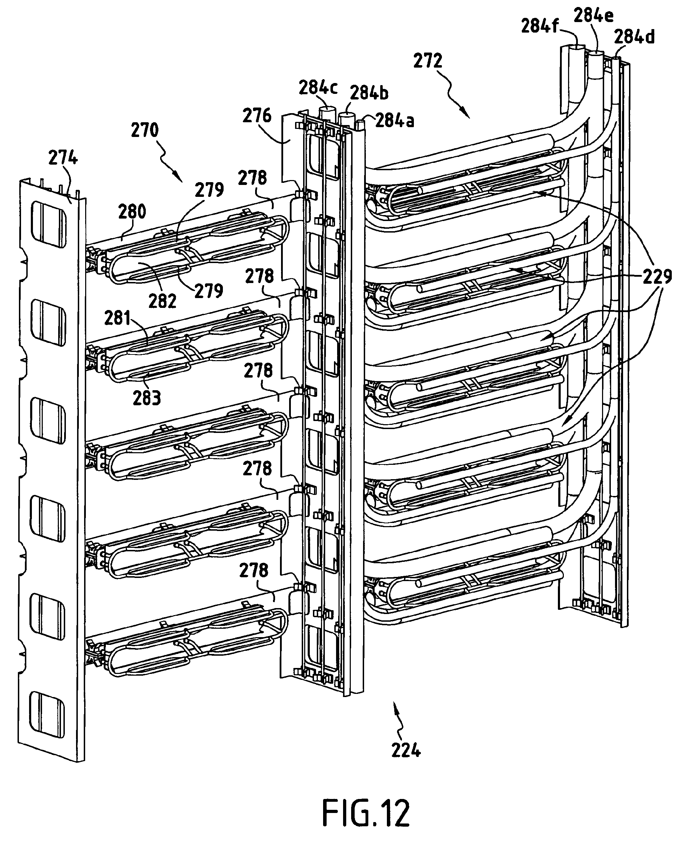

La différence essentielle réside ici dans le support de câblage **224,** bien visible sur la figure **12****.**

Le support de câblage **224** est formé de deux ensembles identiques ou symétriques, appelés châssis **270, 272,** disposées l'un à côté de l'autre de telle manière que le support de câblage **224** présente un plan de symétrie vertical.

Sur la figure **12** on a représenté un premier châssis **270** et un second châssis **272** formant tous deux le support de câblage **224.**

Les deux châssis **270** et **272** étant identiques, on va décrire uniquement le premier châssis **270.**

Comme on le constate sur la figure **12****,** le châssis **270** présente la forme générale d'une échelle, comportant dans l'exemple représenté ici, deux montants verticaux **274, 276** et cinq traverses horizontales **278.** Chacun des deux montants **274, 276** présente sensiblement la forme d'une plaque rectangulaire allongée s'étendant verticalement et disposée dans un plan sensiblement orthogonal à la face du meuble à laquelle le support de câblage est fixé.

Chacune des traverses horizontales **278** comporte une plaque horizontale **280** allongée s'étendant entre les deux montants **274, 276,** disposé dans un plan sensiblement parallèle à la face du meuble **212** à laquelle le support de câblage **224** est fixé.

Chacune des plaques horizontales **280** est fixée par ses extrémités à des bords latéraux des montants **274, 276.**

Lorsque le support de câblage **224** est fixé au meuble de l'armoire électrique selon la troisième invention, on constate que chacune des traverses **278** est disposée sensiblement dans le prolongement du plan de l'une des étagères **216.**

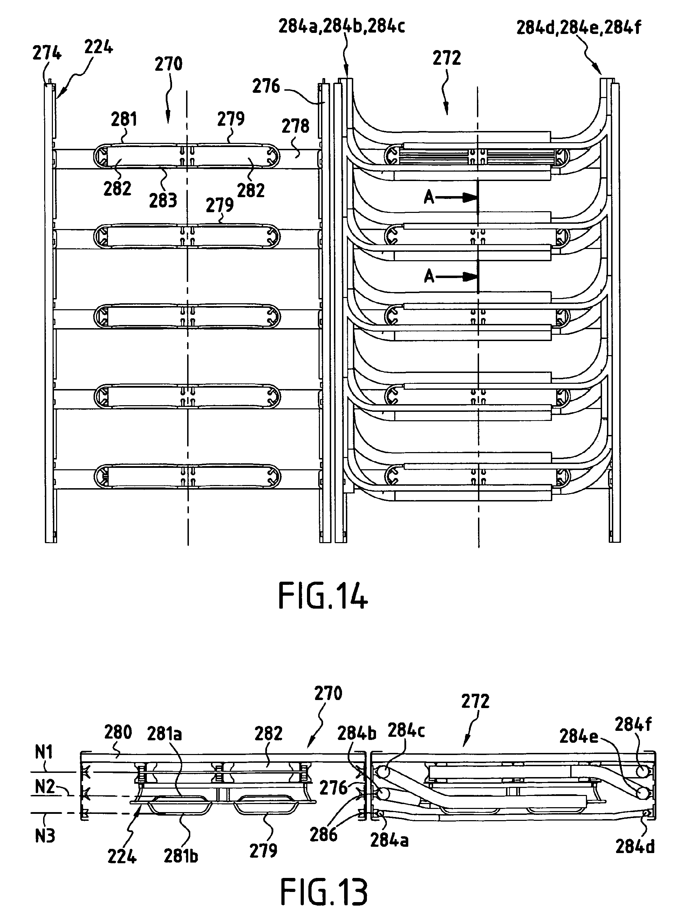

Comme on le voit sur les figures **13** et **14** chacune des traverses **278** comporte en outre un longeron **282** fixé le long de la plaque horizontale **280.** Ce longeron **282** comprend une partie inférieure et une partie supérieure sur lesquels sont disposés des moyens pour supporter des faisceaux de câbles **229** dans un premier plan vertical **N1.**

Chacune des traverses **278** comporte en outre des barreaux **279** fixés au longeron **282** et s'étendant horizontalement, parallèlement à la direction du longeron **282.**

Ces barreaux **279** comportent une paire de barreaux supérieurs **281** et une paire de barreaux inférieurs **283,** chacune des deux paires étant disposée dans un plan sensiblement horizontal.

En outre, chacune des paires de barreaux **281, 283** précitées comporte un premier barreau **281a, 283a,** disposé dans un second plan vertical **N2** et un second barreau **281b, 283b** disposé dans un troisième plan vertical **N3** distinct du premier, les deux plans verticaux étant parallèles à la face du meuble **212.**

A l'aide des figures **12** et **14****,** on va maintenant décrire comment les faisceaux de câbles **229** sont assemblés aux éléments de support constitués par les longerons **282** et les barreaux **279.**

Le support de câblage **224** est apte à recevoir six routes **284a, 284b, 284c, 284d, 284e** et **284f** correspondant en fait à trois types de signaux, connus par ailleurs, **S, M** et **R,** qui sont doublés en raison de la redondance.

Les faisceaux de câbles principaux correspondant à ces routes sont amenés vers le support de câblage **224** à partir d'une zone située au-dessus du support de câblage.

Chacun des montants **274, 276** des châssis est apte à supporter trois faisceaux de câbles principaux s'étendant verticalement le long dudit montant **274, 276.**

Comme on le constate sur la figure **13****,** les faisceaux de câbles principaux sont maintenus sensiblement parallèles entre eux par des sièges **286** fixés le long des montants.

Ces sièges **286** permettent de maintenir une distance suffisante entre les faisceaux de câbles principaux, et cela sur toute la hauteur du support de câblage **224.** Les règles de ségrégation sont donc respectées en ce qui concerne les faisceaux de câbles principaux.

À partir de chacun des faisceaux de câbles principaux et pour chacune des traverses **278,** est issu un faisceau de câbles secondaire **229** s'étendant sensiblement horizontalement.

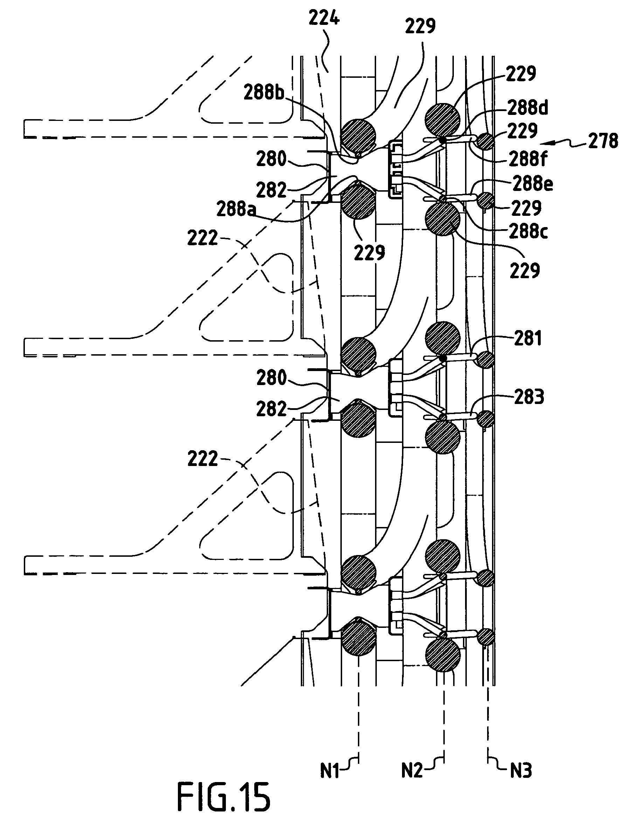

Comme on le constate sur la figure **15****,** chacune des traverses **278** comprend six moyens de support référencés **288a, 288b, 288c, 288d, 288e** et **288f,** aptes à supporter six faisceaux de câbles secondaires **229** issus des six routes précitées. Comme on l'a déjà vu ci-dessus, un longeron **282** est apte à supporter deux faisceaux de câbles secondaires **229** et les deux paires de barreaux horizontaux **281, 283** précités sont aptes à supporter quatre faisceaux de câbles secondaires **229.**

Les six moyens de support **288a, 288b, 288c, 288d, 288e** et **288f** sont disposés de manière à maintenir les faisceaux de câbles secondaires **229** éloignés les uns des autres afin de respecter les règles de ségrégation.

Ce type d'armoire électrique est particulièrement avantageux lorsque le meuble présente de grandes dimensions. Il est alors possible d'utiliser plusieurs châssis disposés les uns à côté des autres.

Il est également particulièrement intéressant dans le cas où les règles de ségrégation sont sévères et que les faisceaux de câbles doivent être suffisamment éloignés les uns des autres. La grande profondeur des montants **274, 276** permet d'assurer la ségrégation des faisceaux de câbles secondaires **229.**

Le support de câblage **224** de l'armoire électrique **210** selon la troisième invention offre une construction rigide, ce qui lui permet d'être utilisée lorsque les contraintes mécaniques sont sévères.

L'invention concerne également un procédé pour câbler une armoire électrique conforme à la présente invention.

Selon ce procédé, on dispose de câbles électriques groupés en faisceaux de câbles dont les extrémités sont équipées de connecteurs, chacun des faisceaux correspondant à un signal particulier.

On dispose également du support de câblage **24, 124, 224** selon l'invention. Toutefois, à ce stade, il n'est pas utile de disposer ni du meuble **12, 112, 212** ni des équipements électriques **14, 114, 214.**

Ensuite, on assemble les faisceaux de câbles au support de câblage. Pour ce faire, on assemble les faisceaux de câbles principaux aux montants, tandis que les faisceaux de câbles secondaires **29, 129, 229,** issus des faisceaux de câbles principaux, sont assemblés aux traverses **38, 138, 280.**

En l'espèce, on assemble les faisceaux de câbles secondaires **29, 129, 229** aux barreaux **46, 48, 146, 148** et/ou aux longerons **282,** en fonction du mode de réalisation de l'armoire électrique.

En l'espèce, les faisceaux de câbles secondaires **229** sont fixés aux barreaux, aux longerons ou bien aux montants par l'intermédiaire d'attaches non représentées ici.

On peut alors réaliser les opérations de finition, de modifications finales du câblage et de test électriques de l'ensemble du câblage.

Lorsque ces opérations sont achevées, on vient ensuite fixer le support de câblage **24, 124, 224** à la face du meuble **12, 112, 212,** puis on fixe les connecteurs aux supports métalliques dans lesquelles viennent s'insérer les équipements électriques.

Mis à part les deux dernières étapes, on comprend que l'opération de câblage peut être avantageusement réalisée en l'absence du meuble et des équipements électriques.

## Revendications

1. Armoire électrique (10, 110, 210), comprenant ;
- un meuble (12, 112, 212) apte à recevoir une pluralité d'équipements électriques (14, 114, 214) et apte à recevoir une pluralité de faisceaux de câbles électriques (26, 28, 30, 29, 32, 129, 229) fixés à une face du meuble (12, 112, 212) pour la connexion .électrique desdits équipements électriques (14, 114, 214),
l'armoire comprenant en outre un support de câblage apte à être fixé de manière démontable audit meuble, ledit support de câblage (24, 124, 224) comportant des éléments de support croisés (38, 40, 138, 140, 274, 276, 278) sur lesquels, en usage, des faisceaux de câbles électriques (29, 129, 229) sont assemblés, **caractérisée en ce que** ledit support de câblage, lorsqu'il est fixé à la face du meuble, s'étend sensiblement dans un plan parallèle à ladite face du meuble et **en ce que** ledit support de câblage (24, 124, 224) comporte des moyens de fixation (36, 137) pour sa fixation à la face du meuble (12, 112, 212), de façon que lesdits câbles électriques peuvent être assemblés au support de câblage (24, 124, 224) avant sa fixation audit meuble (12, 112, 212).

2. Armoire électrique selon la revendication **1, caractérisée en ce que** les éléments de support croisés (38, 40, 138, 140, 274, 276, 278) comportent des traverses (38, 138, 278) sensiblement horizontales et des montants (40, 140, 274, 276) sensiblement verticaux.

3. Armoire électrique selon la revendication **1** ou **2, caractérisée en ce que** les éléments de support croisés (38, 40, 138, 140, 274, 276, 278) sont disposés dans au moins un plan sensiblement vertical appelé niveau.

4. Armoire électrique selon l'une quelconque des revendications **1** à **3, caractérisée en ce que** les faisceaux de câbles électriques (29, 129, 229) sont assemblés le long des éléments de support croisés.

5. Armoire électrique selon la revendication **2** et l'une quelconque des revendications **1** à **4, caractérisée en ce que** le meuble (12, 112, 212) comporte une pluralité d'étagères horizontales (16, 116) sur lesquelles sont disposés les équipements électriques (14, 114, 214) et **en ce qu'**au moins l'une des traverses (38, 138, 278) est disposée au voisinage du plan de l'une des étagères (16, 116).

6. Armoire selon la revendication **2** et l'une quelconque des revendications **1** à **5, caractérisée en ce qu'**au moins l'une des traverses (38, 138, 278) comporte au moins un module de masse auquel sont reliées les masses électriques des équipements électriques (14, 114, 214).

7. Armoire électrique selon la revendication **2** et l'une quelconque des revendications **1** à **6, caractérisée en ce qu'**au moins l'une des traverses (38, 138, 278) comporte au moins un barreau horizontal (46, 48) supportant au moins l'un des faisceaux de câbles électriques (29, 129, 229).

8. Armoire électrique selon les revendications **3** et **7, caractérisé en ce qu'**au moins l'une des traverses (38, 138, 278) comporte au moins deux paires de barreaux (46, 48, 146, 148, 279) disposées dans au moins deux niveaux (N1, N2) distincts.

9. Armoire électrique selon la revendication **8, caractérisée en ce qu'**au moins l'un des barreaux (44) est localement arqué, de manière à pouvoir faire passer au moins un des faisceaux de câbles d'un barreau d'un premier niveau (N1) vers un barreau d'un deuxième niveau (N2).

10. Armoire électrique selon l'une quelconque des revendications **7** à **9, caractérisée en ce que** les barreaux (46, 48, 146, 148, 279) comprennent des tiges métalliques cylindriques soudées entre elles.

11. Armoire électrique selon la revendication **7** et l'une quelconque des revendications **1** à **10**, **caractérisée en ce qu'**au voisinage de l'intersection de l'un des barreaux et d'un montant (40), ledit barreau (42, 44) est localement arqué.

12. Armoire électrique selon la revendication **2** et l'une quelconque des revendications **1** à **11, caractérisée en ce qu'**au moins l'une des traverses (278) comporte en outre un longeron (282) apte à supporter au moins un des faisceaux de câbles.

13. Armoire électrique selon l'une quelconque des revendications **1** à **12, caractérisée en ce que** la distance entre deux éléments de support croisés (38, 40, 138, 140, 274, 276, 278) est dimensionnée pour respecter les ségrégations entre les faisceaux de câbles électriques (29, 129, 229) assemblés sur ces deux éléments de support.

14. Armoire selon l'une quelconque des revendications **1** à **13** utilisée dans un aéronef, **caractérisée en ce que** le support de câblage (24, 124, 224) est métallique et **en ce qu'**il est relié électriquement à une masse électrique de l'avion.

15. Armoire selon l'une quelconque des revendications **1** à **14, caractérisée en ce que** les équipements électriques (14, 114, 214) sont disposés dans des supports individuels métalliques (22, 122, 222) aptes à être reliés électriquement au support de câblage (24, 124, 224).

16. Armoire selon l'une quelconque des revendications **1** à **15, caractérisée en ce que** le meuble est réalisé dans un matériau non-conducteur.

17. Armoire selon l'une quelconque des revendications **1** à **16, caractérisée en ce que** le support de câblage (24) présente sensiblement les mêmes dimensions en largeur et en hauteur que le meuble à étagères (12).

18. Aéronef comportant une armoire selon l'une quelconque des revendications **1** à **17,** dans lequel l'armoire comporte un meuble intégré à une structure principale de l'aéronef.

19. Support de câblage (24, 124, 224) apte à être fixé de manière démontable à un meuble, ledit support comprenenant des éléments de support croisés (38, 40, 138, 140, 274, 276, 278) sur lesquels, en usage, des faisceaux de câbles électriques (29, 129, 229) sont assemblés, **caractérisé en ce que** en usage ledit support est fixé à la face du meuble, tout en s'étendant sensiblement dans un plan parallèle à ladite face du meuble et **en ce que** ledit support de câblage (24, 124, 224) comporte des moyens de fixation (36, 137) pour sa fixation à la face du meuble (12, 112, 212), de façon que lesdits câbles électriques peuvent être assemblés au support de câblage (24, 124, 224) avant sa fixation audit meuble (12, 112, 212).

20. Procédé de câblage d'une armoire électrique selon l'une quelconque des revendications **1** à **17, caractérisé en ce qu'**on assemble les faisceaux de câbles dont les extrémités sont équipées de connecteurs (23, 123) sur le support de câblage (24, 124, 224), on fixe le support de câblage (24, 124, 224) au meuble (12, 112, 212) et on fixe les connecteurs (23, 123) aux supports d'équipements (22, 122, 222).

## Claims

1. Electrical cabinet (10, 110, 210), including:
- an enclosure (12, 112, 212) designed to house a plurality of electrical equipment units (14, 114, 214) and designed to house a plurality of electrical cable bundles (26, 28, 30, 29, 32, 129, 229) attached to a face of the enclosure (12, 112, 212) for the electrical connection of said electrical equipment units (14, 114, 214),
the cabinet additionally including a wiring support designed to be fixed in removable manner to said enclosure, said wiring support (24, 124, 224) including support elements (38, 40, 138, 140, 274, 276, 278) arranged cross-wise, whereon, when in use, electrical cable bundles (29, 129, 229) are assembled, **characterized in that** said wiring support, when it is attached to the face of the enclosure, extends substantially in a plane parallel to said face of the enclosure, and **in that** said wiring support (24, 124, 224) includes fixing means (36, 137) for its attachment to the face of the enclosure (12, 112, 212), it being possible to assemble said electrical cables to the wiring support (24, 124, 224) before attaching it to said enclosure (12, 112, 212).

2. Electrical cabinet according to claim **1**, **characterized in that** the cross-wise support elements (38, 40, 138, 140, 274, 276, 278) include substantially horizontal cross-members (38, 138, 278) and substantially vertical uprights (40, 140, 274, 276).

3. Electrical cabinet according to claim **1** or **2, characterized in that** the cross-wise support elements (38, 40, 138, 140, 274, 276, 278) are disposed in at least one substantially vertical plane referred to as a level.

4. Electrical cabinet according to any one of claims **1** to **3, characterized in that** the electrical cable bundles (29, 129, 229) are assembled along the cross-wise support elements.

5. Electrical cabinet according to claim **2** and any one of claims **1** to **4, characterized in that** the enclosure (12, 112, 212) includes a plurality of horizontal shelves (16, 116) whereon are disposed the electrical equipment units (14, 114, 214), and **in that** at least one of the cross-members (38, 138, 278) is disposed in proximity to the plane of one of the shelves (16, 116).

6. Cabinet according to claim **2** and any one of claims **1** to **5, characterized in that** at least one of the cross-members (38, 138, 278) includes at least one earthing module to which are connected the electrical earths of the electrical equipment units (14, 114, 214).

7. Electrical cabinet according to claim **2** and any one of claims **1** to **6, characterized in that** at least one of the cross-members (38, 138, 278) includes at least one horizontal bar (46, 48) carrying at least one of the electrical cable bundles (29, 129, 229).

8. Electrical cabinet according to claims **3** and **7, characterized in that** at least one of the cross-members (38, 138, 278) includes at least two pairs of bars (46, 48, 146, 148, 279) disposed at at least two distinct levels (N1, N2).

9. Electrical cabinet according to claim **8, characterized in that** at least one of the bars (44) is locally curved, so as to be capable of allowing at least one of the cable bundles to pass from a bar at a first level (N1) to a bar at a second level (N2).

10. Electrical cabinet according to any one of claims **7** to **9, characterized in that** the bars (46, 48, 146, 148, 279) comprise cylindrical metal rods welded together.

11. Electrical cabinet according to claim **7** and any one of claims **1** to **10, characterized in that** in proximity to the intersection of one of the bars and an upright (40), said bar (42, 44) is locally curved.

12. Electrical cabinet according to claim **2** and any one of claims **1** to **11, characterized in that** at least one of the cross-members (278) additionally includes a rail (282) designed to support at least one of the cable bundles.

13. Electrical cabinet according to any one of claims **1** to **12, characterized in that** the distance between two cross-wise support elements (38, 40, 138, 140, 274, 276, 278) is designed to maintain the required segregations between the electrical cable bundles (29, 129, 229) assembled on these two support elements.

14. Cabinet according to any one of claims **1** to **13,** used in an aircraft, **characterized in that** the wiring support (24, 124, 224) is metallic and **in that** it is electrically connected to an electrical earth of the aircraft.

15. Cabinet according to any one of claims **1** to **14, characterized in that** the electrical equipment units (14, 114, 214) are disposed in individual metal carriers (22, 122, 222) designed to be electrically connected to the wiring support (24, 124, 224).

16. Cabinet according to any one of claims **1** to **15, characterized in that** the enclosure is made of a non-conducting material.

17. Cabinet according to any one of claims **1** to **16, characterized in that** the wiring support (24) has substantially the same dimensions on the width and height as the shelf unit (12).

18. Aircraft including a cabinet according to any one of claims **1** to **17**, in which the cabinet includes an enclosure integral with a principal structure of the aircraft.

19. Wiring support (24, 124, 224) designed to be fixed in removable manner to a enclosure, said support including cross-wise support elements (38, 40, 138, 140, 274, 276, 278), whereon, when in use, electrical cable bundles (29, 129, 229) are assembled, **characterized in that**, when in use, said support is attached to the face of the enclosure while it extends substantially in a plane parallel to said face of the enclosure, and **in that** said wiring support (24, 124, 224) includes fixing means (36, 137) for its attachment to the face of the enclosure (12, 112, 212), it being possible to assemble said electrical cables to the wiring support (24, 124, 224) before attaching it to said enclosure (12, 112, 212).

20. Method of wiring an electrical cabinet according to any one of claims **1** to **17**, **characterized in that** the cable bundles, the ends of which are fitted with connectors (23, 123), are assembled on the wiring support (24, 124, 224), the wiring support (24, 124, 224) is fixed to the enclosure (12, 112, 212) and the connectors (23, 123) are attached to the equipment carriers (22, 122, 222).

## Patentansprüche

1. Schaltschrank (10, 110, 210), der folgendes umfaßt:
- ein Möbel (12, 112, 212), das geeignet ist, eine Vielzahl elektrischer Geräte (14, 114, 214) aufzunehmen, und das geeignet ist, eine Vielzahl von an einer Seite des Möbels (12, 112, 212) befestigten Kabelbäumen (26, 28, 30, 29, 32, 129, 229) für die elektrische Verbindung der elektrischen Geräte (14, 114, 214) aufzunehmen,
wobei der Schrank ferner einen Kabelträger aufweist, der geeignet ist, an dem Möbel abnehmbar befestigt zu werden, wobei der Kabelträger (24, 124, 224) gekreuzte Tragelemente (38, 40, 138, 140, 274, 276, 278) umfaßt, an denen im Gebrauch Kabelbäume (29, 129, 229) angebracht sind, **dadurch gekennzeichnet, daß** der Kabelträger, wenn er an der Seite des Möbels befestigt ist, im wesentlichen in einer zu der genanten Seite des Möbels parallelen Ebene verläuft, und daß der Kabelträger (24, 124, 224) Befestigungsmittel (36, 137) für seine Befestigung an der Seite des Möbels (12, 112, 212) aufweist, so daß die elektrischen Kabel mit dem Kabelträger (24, 124, 224) vor dessen Befestigung an dem Möbel (12, 112, 212) verbunden werden können.

2. Schaltschrank nach Anspruch 1, **dadurch gekennzeichnet, daß** die gekreuzten Tragelemente (38, 40, 138, 140, 274, 276, 278) im wesentlichen horizontale Querstreben (38, 138, 278) sowie im wesentlichen vertikale Streben (40, 140, 274, 276) umfassen.

3. Schaltschrank nach Anspruch 1 oder 2, **dadurch gekennzeichnet, daß** die gekreuzten Tragelemente (38, 40, 138, 140, 274, 276, 278) in wenigstens einer im wesentlichen vertikalen Ebene, die als Level bezeichnet wird, angeordnet sind.

4. Schaltschrank nach einem der Ansprüche 1 bis 3, **dadurch gekennzeichnet, daß** die Kabelbäume (29, 129, 229) entlang der gekreuzten Tragelemente angebracht sind.

5. Schaltschrank nach Anspruch 2 und einem der Ansprüche 1 bis 4, **dadurch gekennzeichnet, daß** das Möbel (12, 112, 212) eine Vielzahl von horizontalen Regalbrettern (16, 116) umfaßt, auf denen die elektrischen Geräte (14, 114, 214) angeordnet sind, und daß wenigstens eine der Querstreben (38, 138, 278) in der Nähe der Ebene von einem der Regalbretter (16, 116) angeordnet ist.

6. Schrank nach Anspruch 2 und einem der Ansprüche 1 bis 5, **dadurch gekennzeichnet, daß** wenigstens eine der Querstreben (38, 138, 278) wenigstens ein Massemodul aufweist, mit dem die elektrischen Massen der elektrischen Geräte (14, 114, 214) verbunden sind.

7. Schaltschrank nach Anspruch 2 und einem der Ansprüche 1 bis 6, **dadurch gekennzeichnet, daß** wenigstens eine der Querstreben (38, 138, 278) wenigstens einen Horizontalstab (46, 48) umfaßt, der wenigstens einen der Kabelbäume (29, 129, 229) trägt.

8. Schaltschrank nach den Ansprüchen 3 und 7, **dadurch gekennzeichnet, daß** wenigstens eine der Querstreben (38, 138, 278) wenigstens zwei Stabpaare (46, 48, 146, 148, 279) umfaßt, die in wenigstens zwei unterschiedlichen Leveln (N1, N2) angeordnet sind.

9. Schaltschrank nach Anspruch 8, **dadurch gekennzeichnet, daß** wenigstens einer der Stäbe (44) lokal derart gebogen ist, daß wenigstens einer der Kabelbäume von einem Stab eines ersten Levels (N1) zu einem Stab eines zweiten Levels (N2) geführt werden kann.

10. Schaltschrank nach einem der Ansprüche 7 bis 9, **dadurch gekennzeichnet, daß** die Stäbe (46, 48, 146, 148, 279) untereinander verschweißte zylindrische Metallstangen umfassen.

11. Schaltschrank nach Anspruch 7 und einem der Ansprüche 1 bis 10, **dadurch gekennzeichnet, daß** in der Nähe der Kreuzungsstelle von einem der Stäbe und einer Vertikalstrebe (40) der Stab (42, 44) lokal gebogen ist.

12. Schaltschrank nach Anspruch 2 und einem der Ansprüche 1 bis 11, **dadurch gekennzeichnet, daß** wenigstens eine der Querstreben (278) ferner einen Längsträger (282) umfaßt, der geeignet ist, wenigstens einen der Kabelbäume zu tragen.

13. Schaltschrank nach einem der Ansprüche 1 bis 12, **dadurch gekennzeichnet, daß** der Abstand zwischen zwei gekreuzten Tragelementen (38, 40, 138, 140, 274, 276, 278) bemessen ist, um die Segregationen zwischen den an diesen beiden Tragelementen angebrachten Kabelbäumen (29, 129, 229) einzuhalten.

14. Schrank nach einem der Ansprüche 1 bis 13, der in einem Flugzeug verwendet wird, **dadurch gekennzeichnet, daß** der Kabelträger (24, 124, 224) aus Metall besteht und daß er mit einer elektrischen Masse des Flugzeugs elektrisch verbunden ist.

15. Schrank nach einem der Ansprüche 1 bis 14, **dadurch gekennzeichnet, daß** die elektrischen Geräte (14, 114, 214) in einzelnen Metallträgern (22, 122, 222) angeordnet sind, die geeignet sind, mit dem Kabelträger (24, 124, 224) elektrisch verbunden zu werden.

16. Schrank nach einem der Ansprüche 1 bis 15, **dadurch gekennzeichnet, daß** das Möbel aus einem nichtleitenden Material hergestellt ist.

17. Schrank nach einem der Ansprüche 1 bis 16, **dadurch gekennzeichnet, daß** der Kabelträger (24) im wesentlichen die gleichen Breiten- und Höhenabmessungen wie das mit Regalbrettern versehene Möbel (12) aufweist.

18. Flugzeug, das einen Schrank nach einem der Ansprüche 1 bis 17 aufweist, wobei der Schrank ein in eine Hauptstruktur des Flugzeugs integriertes Möbel umfaßt.

19. Kabelträger (24, 124, 224), der geeignet ist, an einem Möbel abnehmbar befestigt zu werden, wobei der Träger gekreuzte Tragelemente (38, 40, 138, 140, 274, 276, 278) umfaßt, an denen im Gebrauch Kabelbäume (29, 129, 229) angebracht sind, **dadurch gekennzeichnet, daß** der Träger im Gebrauch an der Seite des Möbels befestigt ist und dabei im wesentlichen in einer zu der genanten Seite des Möbels parallelen Ebene verläuft, und daß der Kabelträger (24, 124, 224) Befestigungsmittel (36, 137) für seine Befestigung an der Seite des Möbels (12, 112, 212) aufweist, so daß die elektrischen Kabel mit dem Kabelträger (24, 124, 224) vor dessen Befestigung an dem Möbel (12, 112, 212) verbunden werden können.

20. Verfahren zur Verkabelung eines Schaltschranks nach einem der Ansprüche 1 bis 17, **dadurch gekennzeichnet, daß** die Kabelbäume, deren Enden mit Verbindern (23, 123) versehen sind, an dem Kabelträger (24, 124, 224) angebracht werden, der Kabelträger (24, 124, 224) an dem Möbel (12, 112, 212) befestigt wird und die Verbinder (23, 123) an den Geräteträgern (22, 122, 222) befestigt werden.
